# EUROPÄISCHE PATENTANMELDUNG

(11) **EP 4 235 754 A1**
(43) Veröffentlichungstag der Anmeldung: **30.08.2023**
(21) Anmeldenummer: 22163532.9
(22) Anmeldetag: 22.03.2022
(51) Int. Cl.: H01L 21/48, H01L 23/473

(54) **HALBLEITERANORDNUNG MIT EINEM ERSTEN HALBLEITERELEMENT UND EINEM ERSTEN VERBINDUNGSELEMENT**

(30) Priorität: 23.02.2022 EP 22158230
(71) Anmelder: Siemens Aktiengesellschaft, 80333 München (DE)
(72) Erfinder: Danov, Vladimir, 91056 Erlangen (DE); Kneißl, Philipp, 90427 Nürnberg (DE); Müller, Volker, 90459 Nürnberg (DE); Neugebauer, Stephan, 91058 Erlangen (DE); Schwarz, Florian, 90766 Fürth (DE)
(74) Vertreter: Siemens Patent Attorneys

(57) **Zusammenfassung**

Die Erfindung betrifft ein Halbleiteranordnung (2) mit einem Halbleiterelement (4) und zumindest einem Verbindungselement (22, 24, 26), wobei das Halbleiterelement (4) zumindest einen Kontakt (10, 12, 14) aufweist, wobei zumindest ein Verbindungselement (22, 24, 26) mit einem Kontakt (10, 12, 14) des Halbleiterelements (4) verbunden ist. Um die Entwärmung der Halbleiteranordnung (2) auf kostengünstige und einfache Weise zu verbessern, wird vorgeschlagen, dass das Verbindungselement (22, 24, 26) eine Kühlkanalstruktur (30) mit zumindest einem Kühlkanal (32) aufweist, welcher zumindest teilweise mittels eines FSC-Verfahrens hergestellt ist.

## Beschreibung

Die Erfindung betrifft eine Halbleiteranordnung mit einem Halbleiterelement und zumindest einem Verbindungselement, wobei das Halbleiterelement zumindest einen Kontakt aufweist, wobei zumindest ein Verbindungselement mit einem Kontakt des Halbleiterelements verbunden ist.

Ferner betrifft die Erfindung einen Stromrichter mit mindestens einer Halbleiteranordnung nach einem der vorherigen Ansprüche.

Darüber hinaus betrifft die Erfindung ein Verfahren zur Herstellung einer Halbleiteranordnung mit einem Halbleiterelement und zumindest einem Verbindungselement, wobei das Halbleiterelement zumindest einen Kontakt aufweist, wobei zumindest ein Verbindungselement mit einem Kontakt des Halbleiterelements verbunden wird.

Derartige Anordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Die Halbleiteranordnungen in einem Stromrichter werden üblicherweise in Form von Leistungshalbleitermodulen realisiert, welche beispielsweise mittels Stromschienen kontaktiert werden. Beispielsweise mittels einer planaren Aufbau- und Verbindungstechnik ist unter anderem eine erhöhte Miniaturisierung erreichbar.

Die Offenlegungsschrift WO 2020/249479 A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet. Über das erste Verbindungselement wird eine stoffschlüssige Verbindung zwischen den Schaltungsträgern hergestellt. Das zweite Halbleiterbauelement liegt an der Unterseite des ersten Schaltungsträgers an und ist elektrisch mit der ersten oder zweiten Leiterbahn verbunden.

Durch die zunehmende Miniaturisierung der Leistungselektronik in Stromrichtern, insbesondere unter Verwendung einer derartigen planaren Aufbau- und Verbindungstechnik, ergeben sich neue Herausforderungen hinsichtlich der Entwärmung einer Halbleiteranordnung, um eine hohe Zuverlässigkeit bei geringem Platzbedarf, auch unter Berücksichtigung der Herstellungskosten, zu gewährleisten.

Die Offenlegungsschrift EP 3 823 018 A1 beschreibt ein Elektronikmodul. Das Elektronikmodul umfasst eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Die Patentschrift DE 10 2008 063 724 B4 beschreibt eine Sammelschienenanordnung, die umfasst: mehrere Sammelschienen, die eine erste DC-Sammelschiene, eine zweite DC-Sammelschiene und eine dazwischen vorgesehene AC-Sammelschiene in einer vertikal geschichteten Konfiguration umfassen; mehrere Leistungshalbleitereinrichtungen, die mit den mehreren Sammelschienen kontaktiert und dazwischen montiert sind; wobei mindestens eine der Sammelschienen ein eingebautes Kühlsystem umfasst.

Vor diesem Hintergrund besteht die Aufgabe der vorliegenden Erfindung darin, eine Halbleiteranordnung mit einer verbesserten Entwärmung anzugeben, welche auf kostengünstige und einfache Weise herstellbar ist.

Diese Aufgabe wird bei einer Halbleiteranordnung eingangs genannter Art erfindungsgemäß dadurch gelöst, dass das Verbindungselement eine Kühlkanalstruktur mit zumindest einem Kühlkanal aufweist, welcher zumindest teilweise mittels eines FSC-Verfahrens hergestellt ist.

Ferner wird die Aufgabe erfindungsgemäß gelöst durch einen Stromrichter mit mindestens einer derartigen Halbleiteranordnung.

Darüber hinaus wird die Aufgabe erfindungsgemäß bei einem Verfahren eingangs genannter Art dadurch gelöst, dass im Verbindungselement eine Kühlkanalstruktur mit zumindest einem Kühlkanal zumindest teilweise mittels eines FSC-Verfahrens hergestellt wird.

Die in Bezug auf die Halbleiteranordnung nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, die Zuverlässigkeit einer Halbleiteranordnung mit einem Halbleiterelement zu erhöhen, indem die Entwärmung des Halbleiterelements kostengünstig und einfach verbessert wird. Das Halbleiterelement ist beispielsweise ein Leistungshalbleitermodul, welches in einem Gehäuse angeordnet sein kann und zumindest einen Kontakt aufweist. Das Halbleiterelement kann aber auch als ein, insbesondere vertikaler, Halbleiter, insbesondere als ein Insulated-Gate-Bipolar-Transistor (IGBT), ausgeführt sein. Zumindest ein Verbindungselement ist mit einem Kontakt des Halbleiterelements verbunden. Das Verbindungselement kann unter anderem aus einem metallischen Werkstoff, einem Polymer oder einer Polymermatrix hergestellt und zur thermisch leitfähigen Kontaktierung des Halbleiterelements konfiguriert sein. Beispielsweise ist das Verbindungselement als eine Stromschiene oder als ein Kontaktierungs- und/oder Stützelement ausgeführt.

Um eine verbesserte Entwärmung zu gewährleisten, wird im Verbindungselement eine Kühlkanalstruktur mit zumindest einem Kühlkanal angeordnet, was, insbesondere bei einer hohen Integrationsdichte zu einer Wärmespreizung und damit zu einer Verbesserung der Entwärmung des zumindest einen Halbleiterelements führt. Beispielsweise wird die durch den Betrieb des Halbleiterelements entstehende Wärme über Wärmeleitung, Wärmestrahlung und/oder Konvektion an die Umgebung, insbesondere an die umgebende Luft, dissipiert.

Der Kühlkanal der Kühlkanalstruktur des Verbindungselements ist zumindest teilweise mittels eines FSC-Verfahrens hergestellt. Beim FSC-Verfahren bzw. dem Friction Stir Channelling, auf Deutsch Rührreibkanalisieren genannt, handelt es sich um eine Weiterentwicklung des Rührreibschweißens, bei dem das Rührreibverfahren so modifiziert wird, dass das Material absichtlich aus der Masse des Werkstücks herausbewegt und so ein Kanal ausgebildet wird. Durch ein derartiges Verfahren sind Kühlkanäle einfach und kostengünstig herstellbar. Insbesondere sind durch das FSC-Verfahren filigrane Kühlkanäle bei derartigen Verbindungselementen möglichst nahe am Halbleiterelement kostengünstig und präzise realisierbar. Durch das FSC-Verfahren wird ein flexibler Verlauf der Kühlkanalstruktur abhängig von der Geometrie des Bauteils ermöglicht.

Eine weitere Ausführungsform sieht vor, dass das Verbindungselement eine geschlossene Kühlkanalstruktur aufweist. Eine derartige geschlossene Kühlkanalstruktur weist keine externen Anschlüsse zur Zufuhr eines Wärmetransportfluides während des Betriebes auf. Durch eine derartige geschlossene Kanalstruktur sind unter anderem ein Thermosiphon oder eine Heatpipe ausbildbar. Bildet die geschlossene Kühlkanalstruktur einen geschlossenen Kreislauf aus, ist eine pulsierende Heatpipe ausbildbar. Da während des Betriebes kein Wärmetransportfluid über externe Anschlüsse zugeführt bzw. abgeführt werden muss und somit zusätzliche Komponenten, wie z.B. eine Pumpe, entfallen, sind die Herstellung und der Betrieb eines Verbindungselements mit einer geschlossenen Kühlkanalstruktur einfach und kostengünstig.

Eine weitere Ausführungsform sieht vor, dass das Verbindungselement aus einem elektrisch leitfähigen Werkstoff, insbesondere einem metallischen Werkstoff, hergestellt und zur elektrisch leitfähigen Kontaktierung des Kontakts konfiguriert ist. Das Verbindungselement kann unter anderem Kupfer, Aluminium, Silber, Gold, Zinn oder eine ihrer Legierungen enthalten, wodurch eine gute elektrische und thermische Verbindung herstellbar ist.

Eine weitere Ausführungsform sieht vor, dass zumindest ein Kühlkanal der Kühlkanalstruktur mäanderförmig in dem Verbindungselements verlaufend angeordnet ist. Eine mäanderförmige Kühlkanalstruktur ist mittels des FSC-Verfahrens großflächig in einem Prozessschritt und damit einfach und kostengünstig herstellbar und ermöglicht eine effiziente Entwärmung und Wärmespreizung.

Eine weitere Ausführungsform sieht vor, dass die Kühlkanalstruktur ein Wärmetransportfluid enthält. Ein derartiges Fluid kann elektrisch leitfähig und elektrisch nicht-leitfähig ausgeführt sein. Unter anderem kommen Luft, insbesondere deionisiertes, Wasser, eine Wasser-Glykol-Gemisch, dielektrische Flüssigkeiten und/oder Öle infrage. Somit wird einfach und kostengünstig ein Wärmetransport ermöglicht.

Eine weitere Ausführungsform sieht vor, dass das Wärmetransportfluid für eine Zweiphasenkühlung vorgesehen ist. Beispiele für eine Zweiphasenkühlungen sind unter anderem ein Thermosiphon, eine Heatpipe oder eine pulsierende Heatpipe. Insbesondere ist Perfluor-N-alkyl-morpholin aufgrund seiner hohen Wärmeleitfähigkeit, seines Siedepunkts und seiner dielektrischen Eigenschaften gut als elektrisch nichtleitendes Wärmetransportmedium für die Zweiphasenkühlung geeignet. Durch eine derartige Zweiphasenkühlung wird eine effiziente Entwärmung ermöglicht.

Eine weitere Ausführungsform sieht vor, dass der zumindest eine Kühlkanal eine mittels des FSC-Verfahrens hergestellte Öffnung aufweist, wobei die Öffnung zum Einfüllen des Wärmetransportfluides vorgesehen ist. Eine derartige Öffnung entsteht während des FSC-Verfahrens üblicherweise als Nebenprodukt. Durch die Nutzung der Öffnung zum Einfüllen des Wärmetransportfluides wird der Herstellungsprozess weiter vereinfacht und die Herstellungskosten werden durch Reduzierung der Fertigungsschritte weiter gesenkt.

Eine weitere Ausführungsform sieht vor, dass das Halbleiterelement als Leistungshalbleitermodul ausgeführt ist, wobei das Verbindungselement als Stromschiene ausgeführt ist, welche mit dem ersten Kontakt des Leistungshalbleitermoduls über eine kraftschlüssige Verbindung, insbesondere eine Schraubverbindung, verbunden ist. Ein derartiges Leistungshalbleitermodul umfasst beispielsweise Leistungshalbleiter, die in einem Gehäuse angeordnet sind und, unter anderem, Lastanschlüsse aufweisen, die mittels Stromschienen kontaktiert werden. Eine Schraubverbindung zur Kontaktierung ist zuverlässig und weist einen geringen thermischen Widerstand auf. In derartigen mit den Lastanschlüssen kontaktierten Stromschienen können hohe Ströme auftreten. Ferner sind die Leistungshalbleiter teilweise über die Stromschienen entwärmbar. Über in den Stromschienen angeordnete Kühlkanäle ist eine verbesserte Abgabe der Verlustwärme an die Umgebung erzielbar, sodass eine verbesserte Entwärmung der Halbleiteranordnung erfolgt.

Eine weitere Ausführungsform sieht vor, dass die Stromschiene zumindest eine Lasche aufweist, durch welche zumindest ein Kühlkanal der Kühlkanalstruktur verlaufend angeordnet ist. Eine derartige Lasche kann unter anderem zur Kontaktierung eines Lastanschlusses eines Leistungshalbleitermoduls verwendet werden, sodass der zumindest ein Kühlkanal sehr nahe am Leistungshalbleitermodul angeordnet ist, was einen verbesserten Wärmetransport und damit eine effiziente Entwärmung ermöglicht.

Eine weitere Ausführungsform sieht vor, dass das Halbleiterelement als Leistungshalbleiter ausgeführt ist, welcher zwischen einem ersten Substrat und einem zweiten Substrat angeordnet und zumindest mit dem ersten Substrat, insbesondere stoffschlüssig, verbunden ist, wobei das Verbindungselement über das erste Substrat mit dem Kontakt des Leistungshalbleiters verbunden ist, wobei der Leistungshalbleiter mit dem Verbindungselement über das erste Substrat in einer thermisch leitfähigen Verbindung steht. Eine derartige stoffschlüssige Verbindung kann unter anderem eine Lötverbindung und/oder eine Sinterverbindung aber auch eine adhäsive Verbindung, z.B. mit einem elektrisch und thermisch leitfähigen Kleber, sein. Der Leistungshalbleiter kann unter anderem als vertikaler Leistungstransistor, insbesondere als Insulated-Gate-BipolarTransistor (IGBT), ausgeführt sein. Weitere Beispiele für derartige Leistungshalbleiter sind weitere Transistortypen wie Feldeffekttransistoren aber auch Triacs, Thyristoren und Dioden. Das Verbindungselement kann unter anderem die Funktion eines Kontaktierungs- und Stützelements aufweisen. Über eine in dem Verbindungselement angeordnete Kühlkanalstruktur ist eine verbesserte Entwärmung erzielbar. Beispielsweise kann ein derartiges Verbindungselement im Bereich eines Hotspots eingesetzt werden.

Eine weitere Ausführungsform sieht vor, dass das Verbindungselement zur mechanischen und/oder thermischen Verbindung der Substrate vorgesehen ist. Auf diese Weise wird die Anzahl der erforderlichen Komponenten und der erforderliche Bauraum für die Halbleiteranordnung reduziert. Insbesondere im Bereich von Hotspots kann so einfach und kostengünstig eine Wärmespreizung erzielt werden.

Eine weitere Ausführungsform sieht vor, dass das Verbindungselement aus einem elektrisch leitfähigen Werkstoff, insbesondere einem metallischen Werkstoff, hergestellt und zur elektrisch leitfähigen Verbindung des ersten Substrats mit dem zweiten Substrat konfiguriert ist. Durch die hohe Wärmeleitfähigkeit eines metallischen Werkstoffs ist ein effizienter Wärmetransport erzielbar. Durch die Verwendung der Verbindungselemente zur Herstellung einer elektrisch leitfähigen Verbindung wird die Anzahl der erforderlichen Komponenten und der erforderliche Bauraum für die Halbleiteranordnung reduziert.

Im Folgenden wird die Erfindung anhand der in den Figuren dargestellten Ausführungsbeispiele näher beschrieben und erläutert.

Es zeigen:
- FIG 1: eine schematische Querschnittsdarstellung einer ersten Ausführungsform einer Halbleiteranordnung,
- FIG 2: eine schematische dreidimensionale Darstellung einer zweiten Ausführungsform einer Halbleiteranordnung,
- FIG 3: eine schematische dreidimensionale Darstellung einer dritten Ausführungsform einer Halbleiteranordnung,
- FIG 4: eine schematische Darstellung einer ersten Ausführungsform einer Stromschiene in einer Draufsicht,
- FIG 5: eine schematische Darstellung einer zweiten Ausführungsform einer Stromschiene in einer Draufsicht,
- FIG 6: eine schematische Darstellung einer dritten Ausführungsform einer Stromschiene in einer Draufsicht.
- FIG 7: eine schematische Querschnittsdarstellung einer vierten Ausführungsform einer Halbleiteranordnung,
- FIG 8: eine schematische Darstellung der Herstellung eines Kühlkanals in einem Verbindungselement mittels eines FSC-Verfahrens und
- FIG 9: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

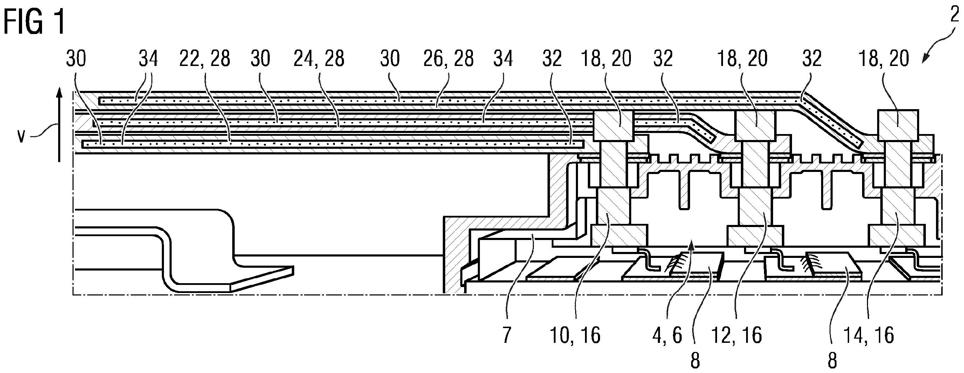

FIG 1 zeigt eine schematische Querschnittsdarstellung einer ersten Ausführungsform einer Halbleiteranordnung 2 mit einem ersten Halbleiterelement 4, welches als Leistungshalbleitermodul 6 ausgeführt ist. Das Leistungshalbleitermodul 6 weist ein Gehäuse 7 und eine Mehrzahl von Leistungshalbleitern 8 auf, welche unter anderem als, insbesondere vertikale, Transistoren, z.B. als Insulated-Gate-Bipolar-Transistoren (IGBTs), oder weitere Transistortypen, aber auch als ein Triacs, Thyristoren und/oder Dioden ausgeführt sein können. Ferner umfasst das Leistungshalbleitermodul 6 beispielhaft drei Kontakte 10, 12, 14, welche als Lastanschlüsse 16 ausgeführt sind. Die Kontakte 10, 12, 14 des Leistungshalbleitermoduls 6 werden jeweils über eine kraftschlüssige Verbindung 18, welche beispielhaft als eine Schraubverbindung 20 ausgeführt ist, mit einem Verbindungselement 22, 24, 26 verbunden. Die Verbindungselemente 22, 24, 26 sind als Stromschienen 28 ausgeführt, welche in einer vertikalen Richtung v voneinander isoliert übereinander angeordnet sind. Die Stromschienen 28 sind aus einem elektrisch leitfähigen Werkstoff, insbesondere einem metallischen Werkstoff, hergestellt und zur elektrisch leitfähigen Kontaktierung der Leistungshalbleiter 8 im Leistungshalbleitermodul 6 konfiguriert. Beispielsweise enthalten die Stromschienen 28 Kupfer, Aluminium, Silber, Gold, Zinn oder einer ihrer Legierungen. Beispielsweise wird die durch den Betrieb der Leistungshalbleitern 8 im Leistungshalbleitermodul 6 entstehende Wärme über Wärmeleitung, Wärmestrahlung und/oder Konvektion an die Umgebung, insbesondere an die umgebende Luft, dissipiert.

Die Verbindungselemente 22, 24, 26 weisen jeweils eine Kühlkanalstruktur 30 mit zumindest einem Kühlkanal 32 auf. In der Kühlkanalstruktur 30 ist ein Wärmetransportfluid 34 angeordnet, das für eine Zweiphasenkühlung vorgesehen ist. Beispielsweise wird mit der Kühlkanalstruktur 30 ein Thermosiphon, eine Heatpipe oder pulsierende Heatpipe ausgebildet, sodass ein verbesserter Wärmetransport und eine Wärmespreizung erreicht wird. Eine Öffnung zum Befüllen der Kühlkanalstruktur 30 ist aus Gründen der Übersichtlichkeit in FIG 1 nicht dargestellt. Das zweite Verbindungselement 24 und das dritte Verbindungselement 26 der übereinander angeordneten Verbindungselemente 22, 24, 26 weisen jeweils eine Lasche 36 auf, über welche die Verbindung zu den jeweiligen Kontakte 12, 14 des Leistungshalbleitermoduls 6 mittels Schraubverbindung 20 hergestellt wird, wobei zumindest ein Kühlkanal 32 der Kühlkanalstruktur 30 durch die jeweilige Lasche 36 verlaufend angeordnet ist.

Der Kühlkanal 32 der Kühlkanalstruktur 30 ist mittels eines FSC-Verfahrens hergestellt. Bei einem derartigen FSC-Verfahren bzw. Friction Stir Channelling, auf Deutsch Rührreibkanalisieren genannt, handelt es sich um eine Weiterentwicklung des Rührreibschweißens, bei dem das Rührreibverfahren so modifiziert wird, dass das Material absichtlich aus der Masse des Werkstücks herausbewegt und so ein Kanal ausgebildet wird. Ein mittels des FSC-Verfahrens hergestellter Kühlkanal 32 kann unter anderem einen eckigen, insbesondere rechteckigen oder quadratischen Querschnitt aufweisen. Durch ein derartiges FSC-Verfahren sind Kühlkanäle einfach und kostengünstig herstellbar.

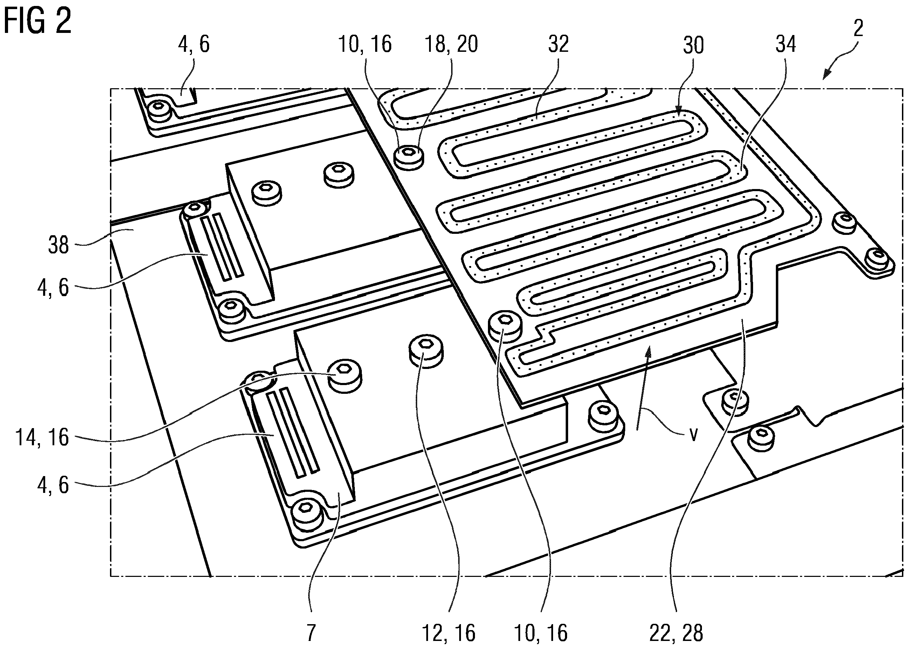

FIG 2 zeigt eine schematische dreidimensionale Darstellung einer zweiten Ausführungsform einer Halbleiteranordnung 2, welche weitere, beispielhaft parallel geschaltete, Leistungshalbleitermodule 6 umfasst, die auf einem gemeinsamen Kühlkörper 38 verschraubt und zumindest thermisch leitfähig sind. Die ersten Kontakte 10 der Leistungshalbleitermodule 6 sind über ein gemeinsames erstes Verbindungselement 22, das als Sammelschiene ausgeführt ist, kontaktiert. Der Kontakt wird über eine Schraubverbindung 20 hergestellt. Der Kühlkanal 32 der geschlossenen Kühlkanalstruktur 30 ist mäanderförmig in dem ersten Verbindungselement 22 verlaufend angeordnet und enthält ein Wärmetransportfluid 34, wobei die Kühlkanalstruktur 30 mit dem Wärmetransportfluid 34 als pulsierende Heatpipe ausgeführt ist. Während des Betriebes der Leistungshalbleitermodule 6 entstehende Wärme wird z.B. über Wärmeleitung, Wärmestrahlung und/oder Konvektion an die Umgebung, insbesondere an die umgebende Luft, dissipiert. Die weitere Ausgestaltung der Halbleiteranordnung 2 in FIG 2 entspricht der in FIG 1.

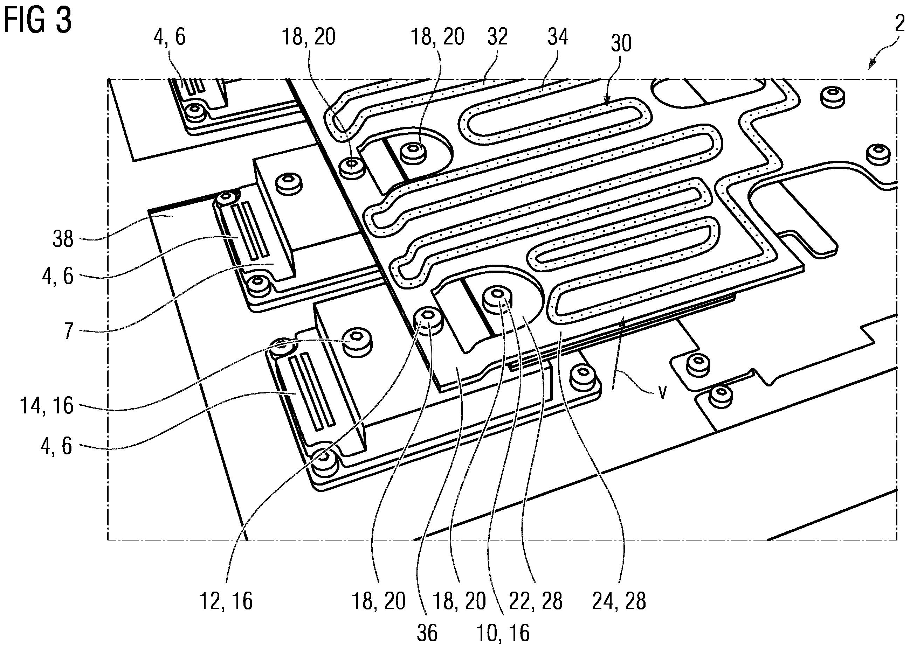

FIG 3 zeigt eine schematische dreidimensionale Darstellung einer dritten Ausführungsform einer Halbleiteranordnung 2, welche zusätzlich ein gemeinsames zweites Verbindungselement 24, das als Sammelschiene ausgeführt ist. Das gemeinsame zweite Verbindungselement 24, das in einer vertikalen Richtung v über dem gemeinsamen ersten Verbindungselement 22 angeordnet ist, ist über Laschen 36 und eine Schraubverbindung 20 mit den zweiten Kontakten 12 der Leistungshalbleitermodule 6 verbunden. Der Kühlkanal 32 der geschlossenen Kühlkanalstruktur 30 des zweiten Verbindungselements 24 ist mäanderförmig im zweiten Verbindungselement 24 verlaufend angeordnet und enthält ein Wärmetransportfluid 34, wobei die Kühlkanalstruktur 30 mit dem Wärmetransportfluid 34 als pulsierende Heatpipe ausgeführt ist. Die weitere Ausgestaltung der Halbleiteranordnung 2 in FIG 3 entspricht der in FIG 2.

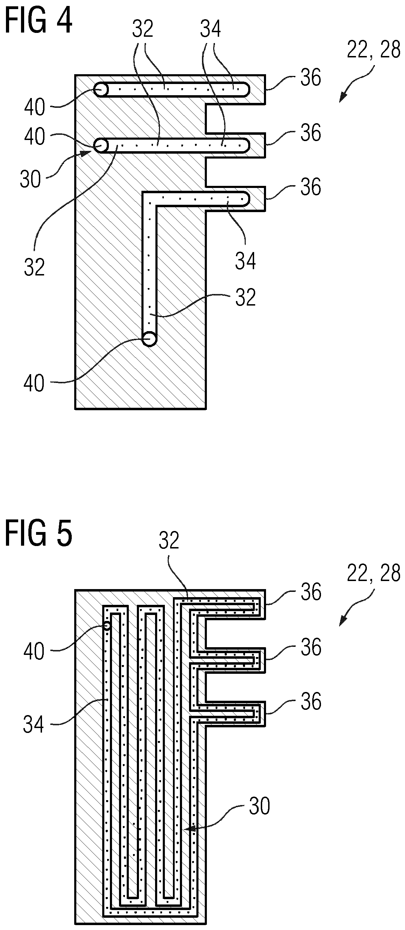

FIG 4 zeigt eine schematische Darstellung einer ersten Ausführungsform einer Stromschiene 28 in einer Draufsicht, wobei die Stromschiene 28 als Sammelschiene mit beispielhaft drei Laschen 36 ausgeführt ist. Die beispielhaft drei geschlossenen Kühlkanäle 32 der Kühlkanalstruktur 30 sind in den Laschen 36 verlaufend ausgebildet und können unter anderem eine Heatpipe oder ein Thermosiphon ausbilden. Die mittels des FSC-Verfahrens hergestellten Kühlkanäle 32 weisen jeweils eine mittels des FSC-Verfahrens hergestellte Öffnung 40 auf, welche nach dem Befüllen der Kühlkanäle 32 mit dem Wärmetransportfluid 34 verschlossen werden. Die weitere Ausgestaltung der Stromschiene 28 in FIG 4 entspricht der in FIG 3.

FIG 5 zeigt eine schematische Darstellung einer zweiten Ausführungsform einer Stromschiene 28 in einer Draufsicht. Der Kühlkanal 32 der geschlossenen Kühlkanalstruktur 30 ist mäanderförmig in der Stromschiene 28 verlaufend angeordnet und verläuft durch die beispielhaft drei Laschen 36. Der mittels des FSC-Verfahrens hergestellte Kühlkanal 32 weist eine mittels des FSC-Verfahrens hergestellte Öffnung 40 auf, welche nach dem Befüllen des Kühlkanals 32 mit dem Wärmetransportfluid 34 verschlossen wird. Die mäanderförmig ausgeführte Kühlkanalstruktur 30 bildet mit dem Wärmetransportfluid 34 eine pulsierende Heatpipe aus. Die weitere Ausgestaltung der Stromschiene 28 in FIG 5 entspricht der in FIG 4.

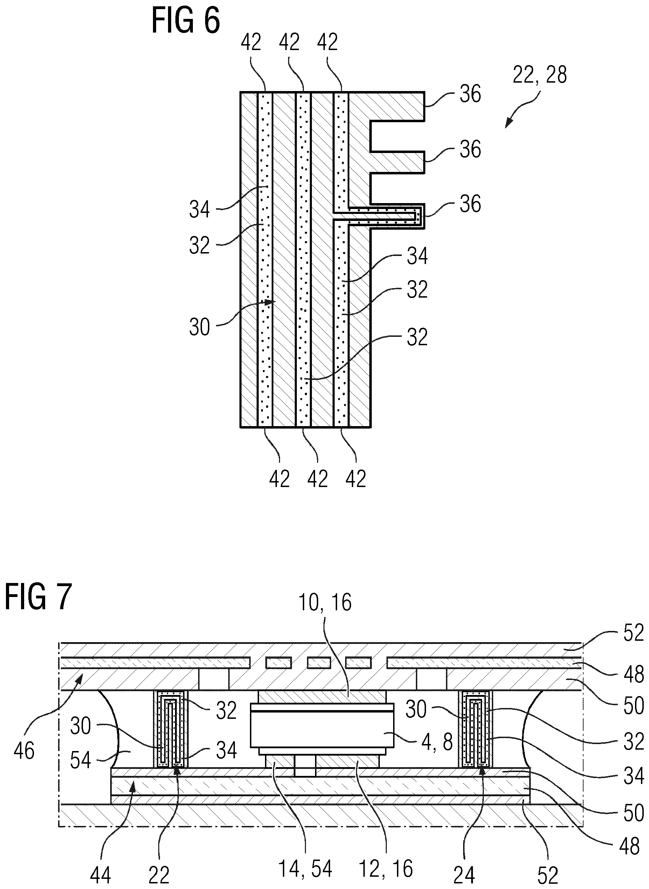

FIG 6 zeigt eine schematische Darstellung einer dritten Ausführungsform einer Stromschiene 28 in einer Draufsicht. Einer der beispielhaft drei offenen Kühlkanäle 32 der Kühlkanalstruktur 30 ist exemplarisch durch eine der drei Laschen 36 verlaufend ausgebildet. Ferner weisen die Kühlkanäle 32 jeweils beidseitig angeordnete Fluidanschlüsse 42 zur externen Zuführung eines Wärmetransportfluids 34 auf.

FIG 7 zeigt eine schematische Querschnittsdarstellung einer vierten Ausführungsform einer Halbleiteranordnung 2, wobei das Halbleiterelement 4 als Leistungshalbleiter 8 ausgeführt ist, welcher zwischen einem ersten Substrat 44 und einem zweiten Substrat 46 angeordnet und mit den Substraten 44, 46 stoffschlüssig verbunden ist. Die stoffschlüssige Verbindung kann unter anderem eine Lötverbindung und/oder eine Sinterverbindung aber auch eine adhäsive Verbindung, z.B. mit einem elektrisch und thermisch leitfähigen Kleber, sein. Die Substrate 44, 46 weisen jeweils eine dielektrische Materiallage 48, eine auf einer dem Halbleiterelement 4 zugewandten Seite angeordnete erste Metallisierung 50 und eine auf einer dem Halbleiterelement 4 abgewandten Seite angeordnete zweite Metallisierung 52 auf. Die dielektrische Materiallage 48 kann unter anderem einen keramischen Werkstoff, beispielsweise Aluminiumnitrid oder Aluminiumoxid, oder einen organischen Werkstoff, beispielsweise ein Polyamid oder Epoxidharz, enthalten.

Der Leistungshalbleiter 8 ist beispielhaft als vertikaler Leistungstransistor, insbesondere als Insulated-Gate-BipolarTransistor (IGBT), ausgeführt. Der Leistungstransistor ist über einen ersten Kontakt 10, welcher als Lastanschluss 16, insbesondere als Kollektor-Anschluss, ausgeführt ist, mit der ersten Metallisierung 50 des zweiten Substrats 46 verbunden. Auf einer dem ersten Kontakt 10 gegenüberliegenden Seite ist der Leistungstransistor über einen zweiten Kontakt 12, welcher als Lastanschluss 16, insbesondere als Emitter-Anschluss, ausgeführt ist, und einen dritten Kontakt 14, weleher als Steueranschluss, insbesondere als Gate-Anschluss, ausgeführt ist, mit der ersten Metallisierung 50 des ersten Substrats 44 verbunden.

Das erste Verbindungselement 22 ist über die erste Metallisierung 50 des ersten Substrats 44 elektrisch leitfähig mit dem dritten Kontakt 14 verbunden, während das zweite Verbindungselement 24 über die erste Metallisierung 50 des ersten Substrats 44 elektrisch leitfähig mit dem zweiten Kontakt 12 des Leistungshalbleiters 8 verbunden ist. Ferner sind die Verbindungselemente 22, 24 zur mechanischen und thermischen Verbindung der Substrate 44,46 vorgesehen. Die Verbindungselemente 22, 24 sind darüber hinaus aus einem elektrisch leitfähigen Werkstoff, insbesondere einem metallischen Werkstoff, hergestellt und zur elektrisch leitfähigen Verbindung des ersten Substrats 44 mit dem zweiten Substrat 46 konfiguriert. Somit haben die Verbindungselemente 22, 24 unter anderem die Funktion eines Kontaktierungs- und Stützelements. Zwischen den Substraten 44, 46 ist ein Vergussmaterial 54 angeordnet, in welchem das Halbleiterbauelement 4 sowie die Verbindungselemente 22, 24 eingebettet sind.

Die Verbindungselemente 22, 24, welche unter anderem quaderförmig ausgeführt sein können, weisen jeweils eine geschlossene Kühlkanalstruktur 30 mit jeweils einem mäanderförmig im jeweiligen Verbindungselement 22, 24 verlaufenden Kühlkanal 32 auf. Der Kühlkanal 32 der Kühlkanalstruktur 30 ist mittels eines FSC-Verfahrens hergestellt. Im Kühlkanal 32 ist ein Wärmetransportfluid 34 angeordnet, das für eine Zweiphasenkühlung vorgesehen ist. Die mäanderförmig ausgeführte Kühlkanal 32 der Kühlkanalstruktur 30 bildet mit dem Wärmetransportfluid 34 eine pulsierende Heatpipe aus. Die weitere Ausgestaltung der Halbleiteranordnung 2 in FIG 7 entspricht der in FIG 1.

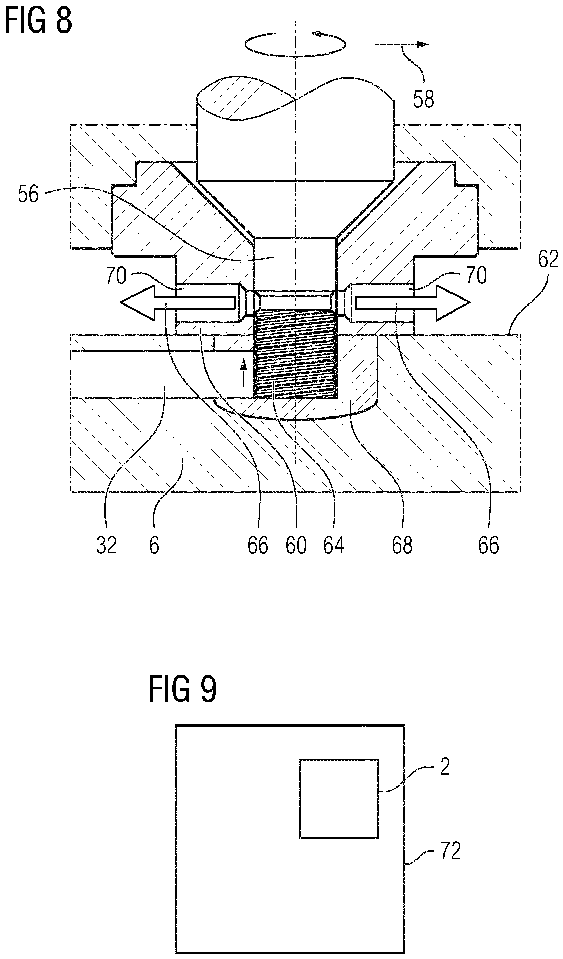

FIG 8 zeigt eine schematische Darstellung der Herstellung eines Kühlkanals 32 in einem Verbindungselement 22 mittels eines FSC-Verfahrens. Eine rotierenden Sonde 56 taucht in das Verbindungselement 22 ein und wird in eine Bewegungsrichtung 58 verfahren, wobei eine Schulter 60 eine Oberfläche 62 des Verbindungselements 22 berührt. Durch die Rotationsbewegung eines gewindeartig profilierten rotierenden Stiftes 64 wird der metallische Werkstoff des Verbindungselements 22 plastifiziert. Es erfolgt eine Extrusion 66 eines Teils des plastifizierten Materials 68, das über zumindest eine Extrusionsöffnung 70 ausgestoßen wird. Diese Materialsubtraktion führt zur Ausbildung des geschlossenen, unter der Oberfläche 62 verlaufenden Kühlkanals 32.

FIG 9 zeigt eine schematische Darstellung eines Stromrichters 72, welcher beispielhaft eine Halbleiteranordnung 2 umfasst.

Zusammenfassend betrifft die Erfindung eine Halbleiteranordnung 2 mit einem Halbleiterelement 4 und zumindest einem Verbindungselement 22, 24, 26, wobei das Halbleiterelement 4 zumindest einen Kontakt 10, 12, 14 aufweist, wobei zumindest ein Verbindungselement 22, 24, 26 mit einem Kontakt 10, 12, 14 des Halbleiterelements 4 verbunden ist. Um die Entwärmung der Halbleiteranordnung 2 auf kostengünstige und einfache Weise zu verbessern, wird vorgeschlagen, dass das Verbindungselement 22, 24, 26 eine Kühlkanalstruktur 30 mit zumindest einem Kühlkanal 32 aufweist, welcher zumindest teilweise mittels eines FSC-Verfahrens hergestellt ist.

## Patentansprüche

1. Halbleiteranordnung (2) mit einem Halbleiterelement (4) und zumindest einem Verbindungselement (22, 24, 26),
wobei das Halbleiterelement (4) zumindest einen Kontakt (10, 12, 14) aufweist,
wobei zumindest ein Verbindungselement (22, 24, 26) mit einem Kontakt (10, 12, 14) des Halbleiterelements (4) verbunden ist,
**dadurch gekennzeichnet, dass**
das Verbindungselement (22, 24, 26) eine Kühlkanalstruktur (30) mit zumindest einem Kühlkanal (32) aufweist, welcher zumindest teilweise mittels eines FSC-Verfahrens hergestellt ist.

2. Halbleiteranordnung (2) nach Anspruch 1,
wobei das Verbindungselement (22, 24, 26) eine geschlossene Kühlkanalstruktur (30) aufweist.

3. Halbleiteranordnung (2) nach einem der Ansprüche 1 oder 2, wobei das Verbindungselement (22, 24, 26) aus einem elektrisch leitfähigen Werkstoff, insbesondere einem metallischen Werkstoff, hergestellt und zur elektrisch leitfähigen Kontaktierung des Kontakts (10, 12, 14) konfiguriert ist.

4. Halbleiteranordnung (2) nach einem der vorherigen Ansprüche,
wobei zumindest ein Kühlkanal (32) der Kühlkanalstruktur (30) mäanderförmig in dem Verbindungselements (22, 24, 26) verlaufend angeordnet ist.

5. Halbleiteranordnung (2) nach einem der vorherigen Ansprüche,
wobei die Kühlkanalstruktur (30) ein Wärmetransportfluid (34) enthält.

6. Halbleiteranordnung (2) nach Anspruch 5,
wobei das Wärmetransportfluid (34) für eine Zweiphasenkühlung vorgesehen ist.

7. Halbleiteranordnung (2) nach einem der Ansprüche 5 oder 6, wobei der zumindest eine Kühlkanal (32) eine mittels des FSC-Verfahrens hergestellte Öffnung (40) aufweist,
wobei die Öffnung (40) zum Einfüllen des Wärmetransportfluides (34) vorgesehen ist.

8. Halbleiteranordnung (2) nach einem der vorherigen Ansprüche,
wobei das Halbleiterelement (4) als Leistungshalbleitermodul (6) ausgeführt ist,
wobei das Verbindungselement (22, 24, 26) als Stromschiene (28) ausgeführt ist,
welche mit dem ersten Kontakt (10, 12, 14) des Leistungshalbleitermoduls (6) über eine kraftschlüssige Verbindung (18), insbesondere eine Schraubverbindung (20), verbunden ist.

9. Halbleiteranordnung (2) nach Anspruch 8,
wobei die Stromschiene (28) zumindest eine Lasche (36) aufweist, durch welche zumindest ein Kühlkanal (32) der Kühlkanalstruktur (30) verlaufend angeordnet ist.

10. Halbleiteranordnung (2) nach einem der Ansprüche 1 bis 7, wobei das Halbleiterelement (4) als Leistungshalbleiter (8) ausgeführt ist,
welcher zwischen einem ersten Substrat (44) und einem zweiten Substrat (46) angeordnet und zumindest mit dem ersten Substrat (44), insbesondere stoffschlüssig, verbunden ist, wobei das Verbindungselement (22, 24, 26) über das erste Substrat (44) mit dem Kontakt (10, 12, 14) des Leistungshalbleiters (8) verbunden ist,
wobei der Leistungshalbleiter (8) mit dem Verbindungselement (22, 24, 26) über das erste Substrat (44) in einer thermisch leitfähigen Verbindung steht.

11. Halbleiteranordnung (2) nach Anspruch 10,
wobei das Verbindungselement (22, 24, 26) zur mechanischen und/oder thermischen Verbindung der Substrate (44, 46) vorgesehen ist.

12. Halbleiteranordnung (2) nach einem der Ansprüche 10 oder 11,
wobei das Verbindungselement (22, 24, 26) aus einem elektrisch leitfähigen Werkstoff, insbesondere einem metallischen Werkstoff, hergestellt und zur elektrisch leitfähigen Verbindung des ersten Substrats (44) mit dem zweiten Substrat (46) konfiguriert ist.

13. Stromrichter (72) mit mindestens einer Halbleiteranordnung (2) nach einem der vorherigen Ansprüche.

14. Verfahren zur Herstellung einer Halbleiteranordnung (2) mit einem Halbleiterelement (4) und zumindest einem Verbindungselement (22, 24, 26),
wobei das Halbleiterelement (4) zumindest einen Kontakt (10, 12, 14) aufweist,
wobei zumindest ein Verbindungselement (22, 24, 26) mit einem Kontakt (10, 12, 14) des Halbleiterelements (4) verbunden wird,
**dadurch gekennzeichnet, dass**
im Verbindungselement (22, 24, 26) eine Kühlkanalstruktur (30) mit zumindest einem Kühlkanal (32) zumindest teilweise mittels eines FSC-Verfahrens hergestellt wird.

15. Verfahren nach Anspruch 14,
wobei mittels des FSC-Verfahrens im zumindest einen Kühlkanal (32) eine Öffnung (40) hergestellt wird,
welche zum Einfüllen eines Wärmetransportfluides (34) vorgesehen ist.
